# EUROPÄISCHE PATENTSCHRIFT

(11) **EP 1 774 841 B1**
(45) Veröffentlichungstag und Bekanntmachung des Hinweises auf die Patenterteilung: **08.09.2010**
(21) Anmeldenummer: 05747522.0
(22) Anmeldetag: 23.04.2005
(51) Int. Cl.: H05K 3/38, H05K 3/02, C04B 37/02

(54) **VERFAHREN ZUM HERSTELLEN EINES METALL-KERAMIK-SUBSTRATES**
METHOD FOR THE PRODUCTION OF A METAL-CERAMIC SUBSTRATE
PROCEDE POUR PRODUIRE UN SUBSTRAT METAL-CERAMIQUE

(30) Priorität: 08.07.2004 DE 102004033226; 14.07.2004 DE 102004033933
(43) Veröffentlichungstag der Anmeldung: 18.04.2007
(73) Patentinhaber: Electrovac AG, 3400 Klosterneuburg (AT)
(72) Erfinder: SCHULZ-HARDER, Jürgen, 91207 Lauf (DE)
(74) Vertreter: Graf, Helmut
(86) Internationale Anmeldenummer: PCT/DE2005/000752
(87) Internationale Veröffentlichungsnummer: WO 2006/005281

(56) Entgegenhaltungen:
- DE-A1- 2 319 854
- PATENT ABSTRACTS OF JAPAN Bd. 2000, Nr. 08, 6. Oktober 2000 (2000-10-06) & JP 2000 150719 A (SUMITOMO METAL ELECTRONICS DEVICES INC), 30. Mai 2000 (2000-05-30)
- PATENT ABSTRACTS OF JAPAN Bd. 2000, Nr. 11, 3. Januar 2001 (2001-01-03) & JP 2000 236052 A (FUJI ELECTRIC CO LTD), 29. August 2000 (2000-08-29)
- PATENT ABSTRACTS OF JAPAN Bd. 2000, Nr. 05, 14. September 2000 (2000-09-14) & JP 2000 034177 A (FUJI ELECTRIC CO LTD), 2. Februar 2000 (2000-02-02)

## Beschreibung

Die Erfindung bezieht sich auf ein Verfahren gemäß Oberbegriff Patentanspruch 1.

Metall-Keramik-Substrate, und dabei insbesondere Kupfer-Keramik-Substrate werden in zunehmendem Maße als Basissubstrate bzw. Leiterplatten auch in Leistungsmodulen eingesetzt, die für höhere Betriebsspannungen bestimmt sind, z.B. für Betriebsspannungen von 600 V und höher. Eine der Anforderungen an derartige Leistungsmodule ist eine ausreichend hohe Teilentladungsfestigkeit. Diese Forderung entspricht der Erkenntnis, dass Teilentladungen, die während des Betriebes eines solchen Moduls auftreten, über eine längere Zeit in den isolierenden Bereichen des Moduls zu elektrisch leitenden Pfaden führen, die die Isolation schwächen und letztendlich auch massive Spannungsdurchschläge verursachen können, so dass es dann zu einem Ausfall des betreffenden Moduls kommt.

Die Forderung nach einer möglichst hohen Teilentladungsfestigkeit bezieht sich dabei auf das gesamte Modul, d. h. jede Einzelkomponente des Moduls muß die Anforderung einer möglichst hohen Teilentladungsfestigkeit erfüllen. Da das jeweilige Metall-Keramik-Substrat eine wesentliche Komponente des jeweiligen Moduls darstellt, gilt diese Anforderung auch für dieses Substrat, obwohl Teilentladungen, die allein innerhalb des Metall-Keramik-Substrates auftreten, dort keine Schädigung der Isolationswirkung verursachen. Die Forderung, dass jede Einzelkomponente die erforderliche Teilentladungsfestigkeit aufweist, resultiert u.a. daraus, dass sich bei Messungen an dem fertigen Modul grundsätzlich nicht feststellen läßt, welche Einzelkomponente des Moduls für Teilentladungen am Modul verantwortlich ist.

Die Messung der Teilentladungsfestigkeit ist in der Norm IEC 1278 festgelegt. Nach diesem Messprinzip wird der jeweilige Prüfling in einer ersten Mess- oder Prüfphase zunächst mit einer deutlich über der Betriebsspannung liegenden Isolationsspannung beaufschlagt-und dann in einer zweiten, anschließenden Mess- oder Prüfphase zunächst mit einer reduzierten, vorbereitenden Mess-Spannung und schließlich mit der eigentlichen Meß- bzw. Prüfspannung, bei der dann die Teilentladung gemessen wird. Die vorbereitende Prüfspannung liegt dabei über der maximalen Betriebsspannung des betreffenden Moduls und die eigentliche Prüfspannung unterhalb der maximalen Betriebsspannung des Moduls. Die Teilentladung darf bei dieser Messung einen Wert von 10 pico Coulomb (pC) nicht übersteigen.

Bekannt ist es, bei der Produktion von Metall-Keramik-Substraten die für Leiterbahnen, Anschlüssen usw. benötigte Metallisierung auf einer Keramik, z.B. auf einer Aluminium-Oxid-Keramik mit Hilfe des sogenannten "Direct- Bonding"- Verfahrens bzw. bei Metallisierungen aus Kupfer mit Hilfe des sogenannten "DCB"-Verfahrens (Direct-Copper-Bonding-Technology) herzustellen, und zwar unter Verwendung von die Metallisierung bildenden Metall- bzw. Kupferfolien oder Metall- bzw. Kupferblechen, die an ihren Oberflächenseiten eine Schicht oder einen Überzug (Aufschmelzschicht) aus einer chemischen Verbindung aus dem Metall und einem reaktiven Gas , bevorzugt Sauerstoff aufweisen.

Bei diesem beispielsweise in der US-PS 37 44 120 oder in der DE-PS 23 19 854 beschriebenen Verfahren bildet diese Schicht oder dieser Überzug (Aufschmelzschicht) ein Eutektikum mit einer Schmelztemperatur unter der Schmelztemperatur des Metalls (z.B. Kupfers), so daß durch Auflegen der Folie auf die Keramik und durch Erhitzen sämtlicher Schichten diese miteinander verbunden werden können, und zwar durch Aufschmelzen des Metalls bzw. Kupfers im wesentlichen nur im Bereich der Aufschmelzschicht bzw. Oxidschicht.

Das DCB-Verfahren weist dann z.B. folgende Verfahrensschritte auf:
- Oxidieren einer Kupferfolie derart, daß sich eine gleichmäßige Kupferoxidschicht ergibt;
- Auflegen des Kupferfolie auf die Keramikschicht;
- Erhitzen des Verbundes auf eine Prozeßtemperatur zwischen etwa 1025 bis 1083°C, z.B. auf ca. 1071 °C;
- Abkühlen auf Raumtemperatur.

Ein Nachteil der DCB-Technik besteht darin, dass prozessbedingt Fehlstellen zwischen der jeweiligen Metallisierung (Kupfer) und der Keramik auftreten. Diese Fehlstellen beeinträchtigen zwar die thermischen Eigenschaften eines unter Verwendung der DCB-Technik hergestellten Metall-Keramik-Substrates kaum, da die Anbindung, d.h. der Flächenanteil der Verbindung zwischen Keramik und Metall, der die Fehlstellen nicht aufweist, im Verhältnis zu der Gesamtfläche des Übergangs zwischen Metall-und Keramik in der Regel größer als 90% ist. Ein gewisses Problem ergibt sich aber durch die Fehlstellen in Bezug auf die Teilentladungsfestigkeit.

Diese prozessbedingten Nachteile des DCB-Prozesses lassen sich beispielsweise durch die sogenannten Aktivlötverfahren vermeiden. Nachteilig ist aber hier, dass ein relativ teueres Lot erforderlich ist und dass zum Strukturieren der auf die Keramik aufgebrachten Metallschichten ein umständliches und mehrstufiges Verfahren notwendig ist, um zwischen benachbarten Leiterbahnen, Kontaktflächen usw. auch das gesamte elektrisch leitende Material (einschließlich Lot) zu entfernen, oder aber dass die die jeweilige Metallisierung bildende Metallschicht vor dem Verbinden mit der Keramikschicht oder dem Keramiksubstrat strukturiert werden muss.

Aufgabe der Erfindung ist es, ein Verfahren aufzuzeigen, mit dem trotz Anwendung des vorteilhaften DCB-Prozesses Fehlstellen vermieden, zumindest aber soweit reduziert werden, dass ein nachteiliger Einfluss auf die Eigenschaften des Metall-Keramik-Substrates und insbesondere auch auf die Teilentladungsfestigkeit nicht mehr feststellbar ist. Zur Lösung dieser Aufgabe ist ein Verfahren entsprechend dem Patentanspruch 1 ausgebildet.

Bei dem erfindungsgemäßen Verfahren wird eine Anbindung der Melallisierungen bzw. der Metallschichten an die Keramik größer als 95% erreicht. Es werden auf jeden Fall Fehlstellen mit einem Durchmesser größer 50 µm vermieden. In überraschender Weise wird die Keramik durch die Nachbehandlung nicht geschädigt.

Unter "Keramiksubstrat" ist im Sinne der Erfindung ganz allgemein eine Keramikschicht zu verstehen. Unter "Metall-Keramik-Substrat" ist im Sinne der Erfindung ganz allgemein ein Substrat bzw. eine Schichtenfolge zu verstehen, die wenigstens eine Keramikschicht und zumindest eine an wenigstens einer Oberflächenseite der Keramikschicht vorgesehene Metallisierung aufweist. Unter "Anbindung" ist im Sinne der Erfindung derjenige Flächenanteil des Übergangs zwischen der jeweiligen Metallisierung und der Keramikschicht zu verstehen, der (Flächenanteil) Fehlstellen nicht aufweist und an dem somit eine unmittelbare Anbindung der Metallschicht an die Keramik besteht.

Die Nachbehandlung erfolgt bei der Erfindung unter Verwendung eines Inertgases als Druckgas mit einem Sauerstoffanteil bzw. Sauerstoffpartialdruck, der unter Berücksichtigung der Nachbehandlungstemperatur so eingestellt ist, dass der Sauerstoffpartialdruck größer ist als derjenige Partialdruck, bei dem eine Zersetzung der Bondgrenze zwischen den Kupfer und Keramik und damit ein Lösen der jeweiligen DCB-Verbindung zwischen dem Kuper und der Keramik auftreten könnte. Der Sauerstoffpartialdruck ist aber noch oben hin so begrenzt, dass keine nennenswerte Oxidation des Kupfers während der Nachbehandlung auftritt. Da mit abnehmender Nachbehandlungstemperatur die Oxidationsrate abnimmt, kann der Sauerstoffpartialdruck bei niedrigen Nachbehandlungstemperaturen entsprechend höher gewählt werden.

Die Erfindung wird im Folgenden anhand der Figuren an Ausführungsbeispielen näher erläutert. Es zeigen:
- Fig. 1: in vereinfachter Darstellung ein Metall-Keramik-Substrat gemäß der Erfindung;
- Fig. 2: in vergrößerter Darstellung den Übergang zwischen der Keramikschicht und einer Metallisierung bei einem Metall-Keramik-Substrat vor der Nachbehandlung;
- Fig. 3 - 6: in jeweils verschiedenen Positionen Verfahrensschritte unterschiedlicher Verfahren zum Herstellen des Metall-Keramik-Substrates der Figur 1;
- Fig. 7: in einer Darstellung ähnlich Figur 1 eine weitere Ausführungsform des Metall- Keramik-Substrates;
- Fig. 8: in verschiedenen Positionen Verfahrensschritte unterschiedlicher Verfahren zum Herstellen des Metall-Keramik-Substrates der Figur 7;
- Fig. 9: in einer Darstellung ähnlich Figur 1 eine weitere Ausführungsform des Metall- Keramik-Substrates;
- Fig. 10: in verschiedenen Positionen Verfahrensschritte unterschiedlicher Verfahren zum Herstellen des Metall-Keramik-Substrates der Figur 9.

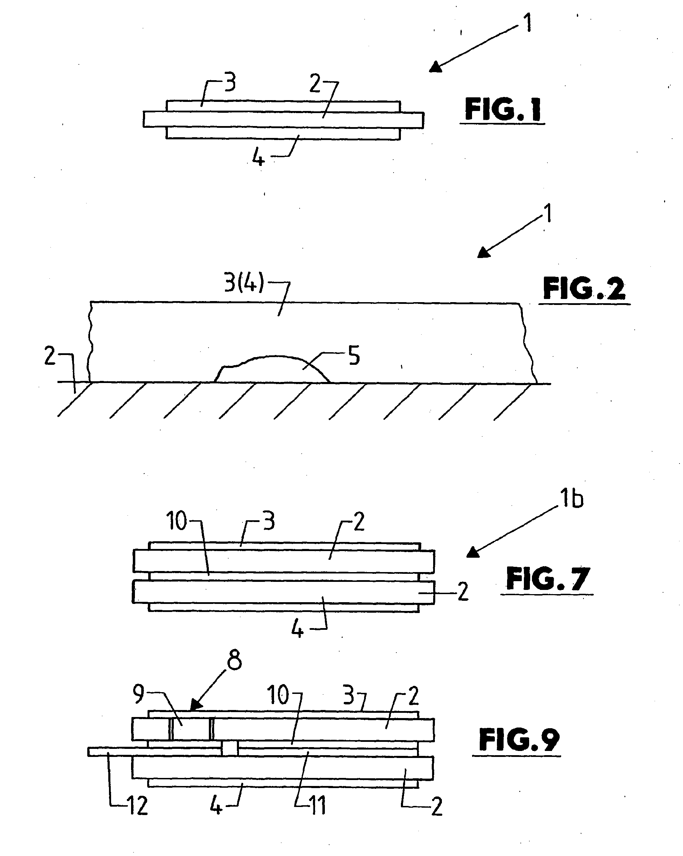

Die Figur 1 zeigt in vereinfachter Darstellung und im Schnitte in Kupfer-Keramik-Substrat 1 bestehend aus der Keramikschicht 2 und den Metallschichten 3 und 4, die jeweils von Folien aus Kupfer oder Kupferlegierung gebildet und mit Hilfe des DCB-Prozesses mit der Keramikschicht 2 verbunden sind. Das Substrat 1 ist beispielsweise das Basis-Substrat oder die Leiterplatte eines Leistungsmoduls für hohe Betriebsspannungen (größer 600 Volt). Wenigstens eine der beiden Metallschichten 3 bzw. 4 ist hierbei dann mit einer bekannten Technik, beispielsweise mit der Maskierungs- und Ätztechnik strukturiert, und zwar zur Bildung von Kontaktflächen, Leiterbahnen usw. für die auf dem Substrat 1 anzuordnenden passiven und/oder aktiven, das Modul bildenden Bauelemente.

Die Figur 2 zeigt den Übergang zwischen einer Metallschicht 3 bzw. 4 und der Keramikschicht nach dem DCB-Prozess, und zwar mit einer Fehlstelle 5.

Um die erforderliche hohe Teilentladungsfestigkeit zu erreichen, wirde das Substrat 1 nach dem Aufbringen der Metallschichten 3 und 4 in einem weiteren Verfahrensschritt auf eine Temperatur unterhalb der Prozesstemperatur des DCB-Prozesses, beispielsweise auf eine Temperatur im Bereich zwischen 450 und 1060° C erhitzt und hierbei zugleich unter Verwendung eines nicht reaktiven Gases bzw. Inertgases z.B. unter Verwendung von Argon oder Stickstoff mit einem Gasdruck im Bereich zwischen 400 und 2000 bar beaufschlagt. Durch diese Nachbehandlung (HIP-Nachbehandlung), bei der die Keramikschicht 2 nicht beschädigt wird, werden Hohlräume bzw. Fehlstellen 5, die sich eventuell am Übergang zwischen der Keramikschicht und der jeweiligen Metallschicht 3 bzw. 4 durch den DCB-Prozess bilden und die Teilentladungsfestigkeit reduzieren, vollständig oder nahezu vollständig beseitigt, so dass das Substrat 1 trotz seiner Ausbildung als DCB-Substrat die Anforderungen an die Teilentladungsfestigkeit voll und ganz erfüllt.

Nachstehend werden verschiedene Möglichkeiten der Herstellung des Metall-Keramik-Substrates 1 an Beispielen näher erläutert.

### Beispiel 1

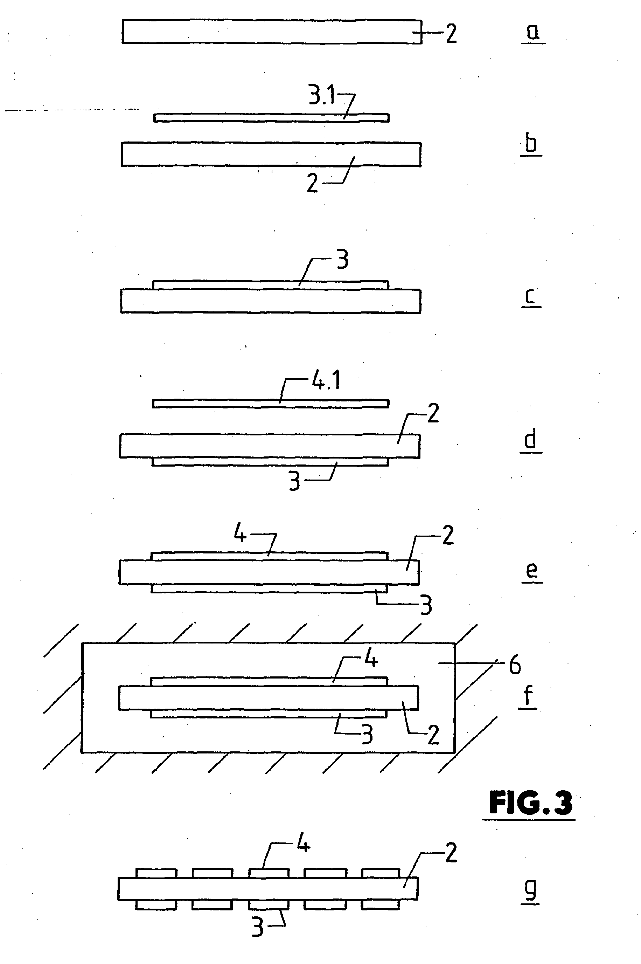

Bei diesem Verfahren, dessen Verfahrensschritte in Figur 3 in den Positionen a - g wiedergegeben sind, wird eine Keramikschicht 2 aus Al₂O₃ verwendet, und zwar mit äußeren Abmessungen von 130 x 180 mm und einer Dicke von 0,38 mm (Position a).

Auf die Keramikschicht 2 wird zunächst einseitig ein die spätere Metallschicht 3 bildender Zuschnitt 3.1 aus einer voroxidierten Kupferfolie aufgelegt (Position b) und die aus der Keramikschicht 2 und dem Zuschnitt 3.1 bestehende Anordnung wird dann in einem geeigneten Ofen unter Sauerstoffausschluss für etwa 10 Minuten erhitzt bzw. vorgesintert, und zwar insbesondere zur Vernichtung der Härte des Kupfermaterials. Im Anschluss daran erfolgt ein Erhitzen der aus der Keramikschicht 2 und des Zuschnittes 3.1 bei einem Sauerstoffgehalt von < 20ppm auf ca. 1072° C, so dass dann nach einem Abkühlen der Zuschnitt 3.1 die mit der einen Oberflächenseite der Keramikschicht durch den DCB-Prozess verbundene Metallschicht 3 bildet (Position c).

Nach dem Wenden der Keramikschicht 2 wird auf die andere Oberflächenseite dieser Keramikschicht ebenfalls ein Zuschnitt 4.2 aus der voroxidierten Kupferfolie aufgelegt (Position d) und die dann aus der Keramikschicht 2, der Metallschicht 3 und dem Zuschnitt 4.1 bestehende Anordnung erneut unter Sauerstoffausschluss für etwa 10 Minuten erhitzt, und zwar wiederum auf eine Temperatur deutlich unterhalb der Prozesstemperatur von etwa 1072° C des DCB-Prozesses. In einem weiteren Verfahrensschritt erfolgt dann das Bonden des Zuschnittes 4.1 mit der Keramikschicht 2, und zwar durch Erhitzen auf die DCB-Prozesstemperatur bei einem Sauerstoffgehalt von < 20ppm (Position e). Nach dem Abkühlen unterhalb der DCB-Prozesstemperatur weist das Substrat dann auch die mit der Keramikschicht 2 verbundene Metallisierung 4.

Zur Vermeidung der Fehlstellen 5 erfolgt dann in einem weiteren Verfahrensschritt die Nachbehandlung des Substrates 1 durch Erhitzen und Druckbeaufschlagung, und zwar in einem geschlossenen Druckraum 6 in einer Schutzgasatmosphäre, beispielsweise Argon-Atmosphäre mit einem Sauerstoffpartialdruck von etwa 6ppm durch Erhitzen auf eine Temperatur von etwa 560° C und bei einem Druck von etwa 1100 bar (Position f). Nach dieser Behandlung wird das Substrat 1 auf Raumtemperatur abgekühlt und es folgt dann ein Strukturieren der Metallschichten 3 und 4 durch Maskieren und Ätzen, so dass auf der Keramikschicht 2 die Metallstrukturen mehrerer Einzelsubstrate, d.h. auf der gemeinsamen Keramikschicht 2 im Mehrfachnutzen eine Vielzahl von Einzelsubstraten gebildet sind (Position g). Durch Laser-Ritzen mit einem geeigneten Laser, beispielsweise CO2-Laser, werden an einer Oberflächenseite der Keramikschicht 2 Sollbruchlinien zwischen den strukturierten Metallflächen der Einzelsubstrate erzeugt, so dass das Mehrfachsubstrat dann in die Einzelsubstrate gebrochen werden kann.

Das Ergebnis dieses Verfahrens sind Substrate mit einer hohen Anbindung der Metallisierungen 3 und 4 an die Keramik, d.h. mit einer Anbindung von wenigstens 95% und mit Fehlstellen 5, deren Durchmesser in der Ebene des Übergangs zwischen der Keramikschicht 2 und der Metallisierung 3 bzw. 4 deutlich kleiner als 50µm ist.

Dieses Verfahren kann auch modifiziert werden, beispielsweise in der Form, dass die Verfahrensschritte a - d zusammengefasst werden, d.h. beidseitig von der Keramikschicht 2 die Zuschnitte 3.1 und 4.1 aus der voroxidierten Kupferfolie angeordnet werden und die Anordnung in einem geeigneten Ofen unter Sauerstoffausschluss erhitzt bzw. gesintert wird, worauf dann anschließend die beiden Zuschnitte 3.1 und 4.1 unter Verwendung des DCB-Prozesses mit der Keramikschicht 2 verbunden werden und zwar bei einem Sauerstoffgehalt < 20ppm und einer Temperatur von ca. 1072° C.

Weiterhin besteht auch die Möglichkeit, auf das Vorsintern der Zuschnitte 3.1 und 4.1 zu verzichten.

### Beispiel 2

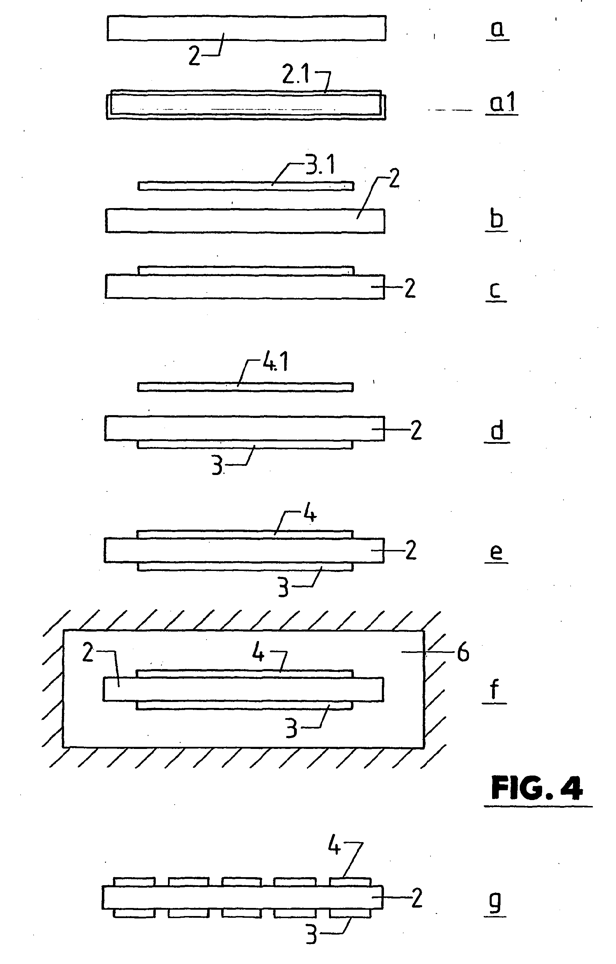

Die Verfahrensschritte dieses Verfahrens sind in der Figur 4 wiedergegeben. Ausgangsmaterial ist eine AlN-Keramikschicht 2 mit den Abmessungen 130 x 180 mm und mit einer Dicke von 2 mm (Position a).

Die Keramikschicht 2 wird mit einer dünnen Schicht 2.1 aus Al₂O₃ versehen, und zwar durch Oxidieren bzw. Behandeln über eine Zeitdauer von 30 Minuten bei einer

Temperatur von 1220° C in einer Stickstoff (N2) und Sauerstoff (O₂) enthaltenden Atmosphäre, wobei das Verhältnis Stickstoff/Sauerstoff 80/20 beträgt (Position a1).

Es schließen sich dann die vorstehend im Zusammenhang mit dem Beispiel 1 beschriebenen Verfahrensschritte b - g an, wobei die Hitze-Druck-Nachbehandlung bei dieser Ausführungsform bei einer Temperatur von etwa 950° C und bei einem Druck von etwa 900 bar erfolgt.

Das Ergebnis dieses Verfahrens ist wiederum ein Substrat 1 mit einer Anbindung der Metallschichten 3 und 4 größer als 95% und ohne Fehlstellen 5 mit einem Durchmesser größer 50µm.

### Beispiel 3

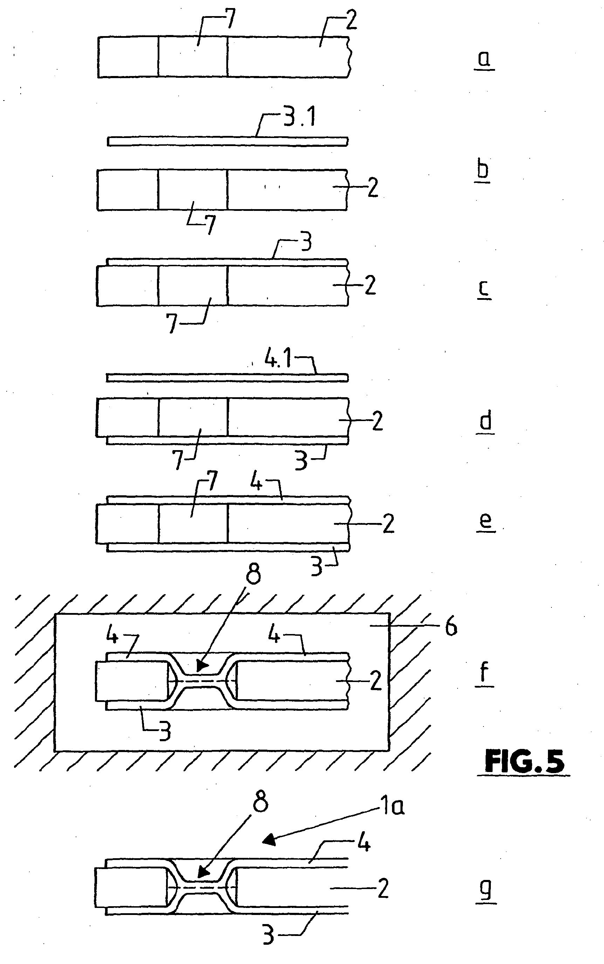

Bei diesem Verfahren, dessen Verfahrensschritte der Figur 5 wiedergegeben sind, wird eine Al₂O₃-Keramikschicht 2 mit den Abmessungen 130 x 180 mm und mit einer Dicke von 0,63 mm verwendet. In die Keramikschicht 2 wird mit geeigneten Mitteln, beispielsweise durch Bohren Löcher 7 eingebracht, von denen der einfacheren Darstellung wegen nur eines gezeigt ist (Position a). Im Anschluss daran erfolgt den im Beispiel 1 angegebenen Verfahrensschritten b - e das Aufbringen der Metallschichten 3 und 4 auf die Keramikschicht 2.

In der anschließenden Nachbehandlung bei einer Temperatur von etwa 800° C und bei einem Druck von 1000 bar (Position f) erfolgt dann nicht nur die Beseitigung der Fehlstellen 5, sondern auch ein Verformen der Metallschichten 3 und 4 in die Löcher 7 hinein und damit ein Verbinden dieser Metallschichten innerhalb der Öffnung 7, so dass eine Vielzahl von Durchkontaktierungen 8 erhalten ist. Im Anschluss an die Nachbehandlung erfolgt dann wiederum das Strukturieren der Metallisierungen 3 und 4, das Ritzen der Keramik mittels eines Lasers und das Vereinzeln der Einzelsubstrate durch Brechen entlang der erzeugten Sollbruchlinien.

Das Ergebnis ist dann ein Substrat 1a, welches nicht nur die hohe Anbindung der Kupferschichten 3 und 4 aufweist, sondern zugleich auch die Durchkontaktierung 7 besitzt (Position g).

### Beispiel 4

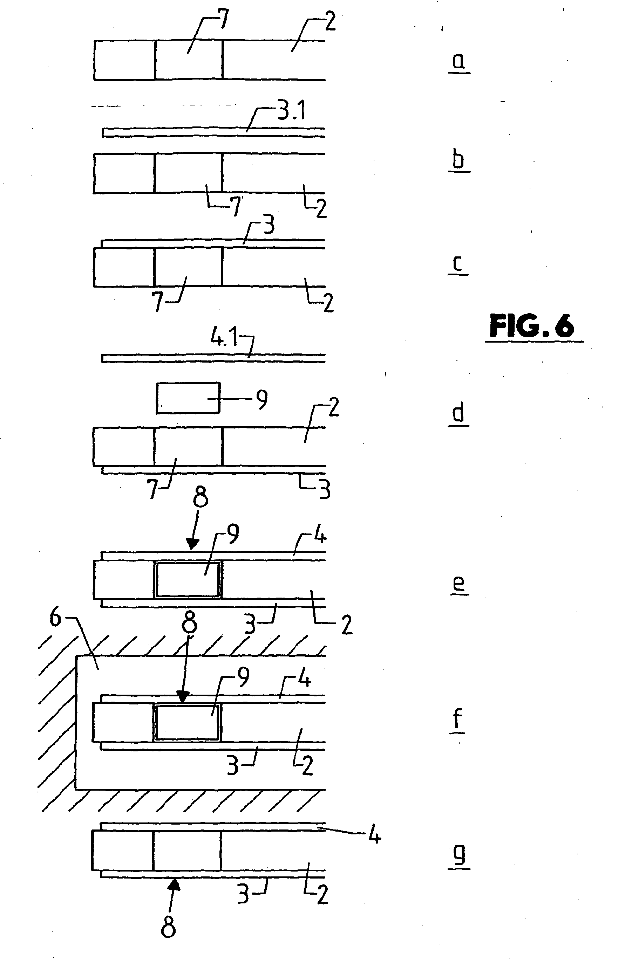

Dieses Beispiel bezieht sich auf ein Verfahren, welches sich von dem Verfahren des Beispiels 3 dadurch unterscheidet, dass entsprechend der Figur 6 nach dem Verfahrensschritt d in jedes Loch 6, welches einen Durchmesser von 0,8 mm aufweist, vor dem Auflegen des Zuschnittes 4.1 jeweils eine Ronde 8 eingesetzt wird, die einen Durchmesser von 0.7 mm und eine axiale Länge von 0,3 mm besitzt.

Im Anschluss daran erfolgt wiederum nach dem Bonden des Zuschnittes 4.1 (Position e) die Nachbehandlung in dem geschlossenen Raum 6 bei einem Druck von etwa 850 bar und einer Temperatur von etwas 1030° C (Position f).

Nach der Strukturierung der Metallschicht 3 und 4 und nach dem Einbringen der Sollbruchlinien durch Laser-Ritzen erfolgt wiederum das Trennen des Mehrfachsubstrates in die Einzelsubstrate.

### Beispiel 5

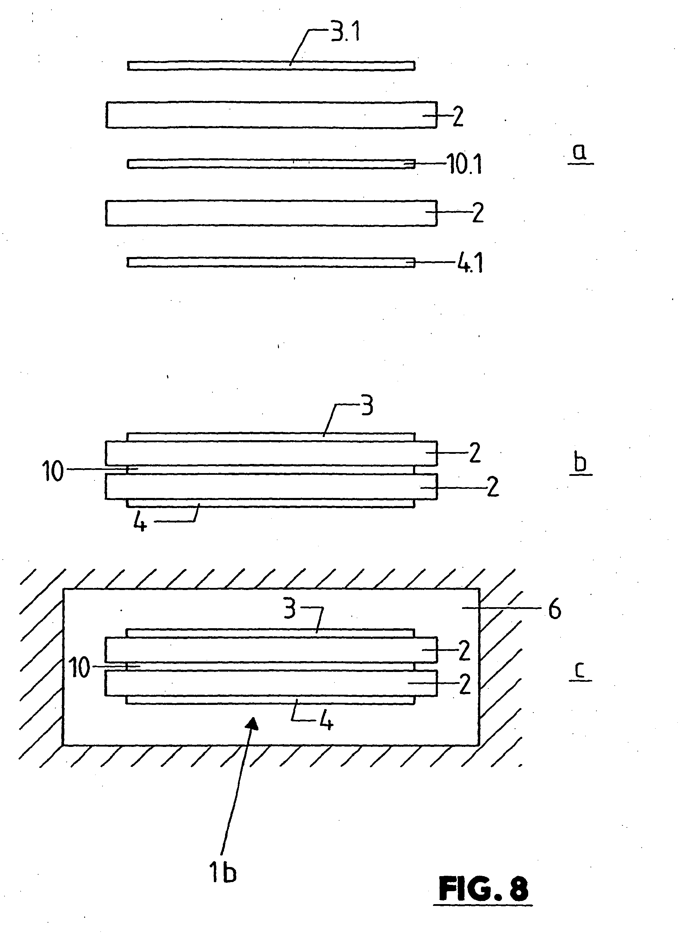

Die Figur 7 zeigt als weitere mögliche Ausführungsform ein mehrschichtiges Substrat 1b, welches zwei Keramikschichten 2, eine obere und eine untere, jeweils freiliegende Metallschicht 3 bzw. 4 sowie eine innere, die beiden Keramikschichten 2 miteinander verbindende Metallschicht 10 aufweist. Sämtliche Metallschichten 3, 4 und 10 sind wiederum von jeweils einem voroxidierten Zuschnitt 3.1, 4.1 bzw. 10.1 aus einer Folie aus Kupfer oder aus einer Kupferlegierung gebildet und besitzen eine Dicke von etwa 0,3 mm. Die Herstellung des Substrates 1b erfolgt beispielsweise mit einem Verfahren entsprechend der Figur 8, dessen einzelne Verfahrensschritte in dem nachfolgenden Beispiel angegeben sind.

Ausgangsmaterialien für die Herstellung des Substrates 1b sind zwei Keramikschichten oder Substrate 2 mit den Abmessungen 60 x 80 mm und mit einer Dicke von 0,38 mm sowie die drei jeweils voroxidierten Zuschnitte 3.1, 4.1 und 10.1 aus der Folie aus Kupfer oder Kupferlegierung (Position a der Figur 8). Diese Elemente werden übereinandergestapelt, so dass sie dicht aufeinander aufliegen und zwischen den beiden Keramikschichten 2 der Zuschnitt 10.1 angeordnet ist und jeder Keramikschicht 2 außerdem der Zuschnitt 3.1 bzw. 4.1 benachbart liegt. Im Anschluss daran erfolgt das Verbinden bzw. Bonden mit Hilfe des DCB-Prozesses, und zwar durch Erhitzen des Stapels auf die DCB-Prozess-Temperatur von ca. 1072° C in einer Schutzgasatmosphäre mit einem Sauerstoffgehalt von weniger als 20 ppm. Nach Beendigung des DCB-Prozesses und nach dem Abkühlen ist bereits die dem Metall-Keramik-Substrat 1b entsprechende Schichtenfolge erhalten (Position b).

Es erfolgt dann die Nachbehandlung bei einem Druck von 750 bar und einer Temperatur von 1030° C (Position c).

Das Ergebnis ist das Substrat 1 in Sandwichaufbau mit einer Anbindung der Metall- bzw. Kupferschichten 3, 4 und 10 an die Oberflächen der Keramikschichten 2 größer 95% und mit einem Fehlstellendurchmesser kleiner 50mµ.

Die Figur 9 zeigt ein Metall-Keramik-Substrat 1c, welches sich von dem Substrat 1b dadurch unterscheidet, dass zwischen der Metallschicht 10 und der unteren Keramikschicht 2 eine weitere strukturierte Metallschicht 11 vorgesehen ist und mit wenigstens einem Abschnitt 12 über eine Seite des Substrates 1c vorsteht und hierdurch äußere Anschlüsse für das mit dem Metall-Keramik-Substrat 1c aufgebaute Modul bildet.

Die Herstellung des Substrates 1c erfolgt z.B. in Verfahrensschritten, die im nachfolgendem Beispiel 6 beschrieben sind.

### Beispiel 6

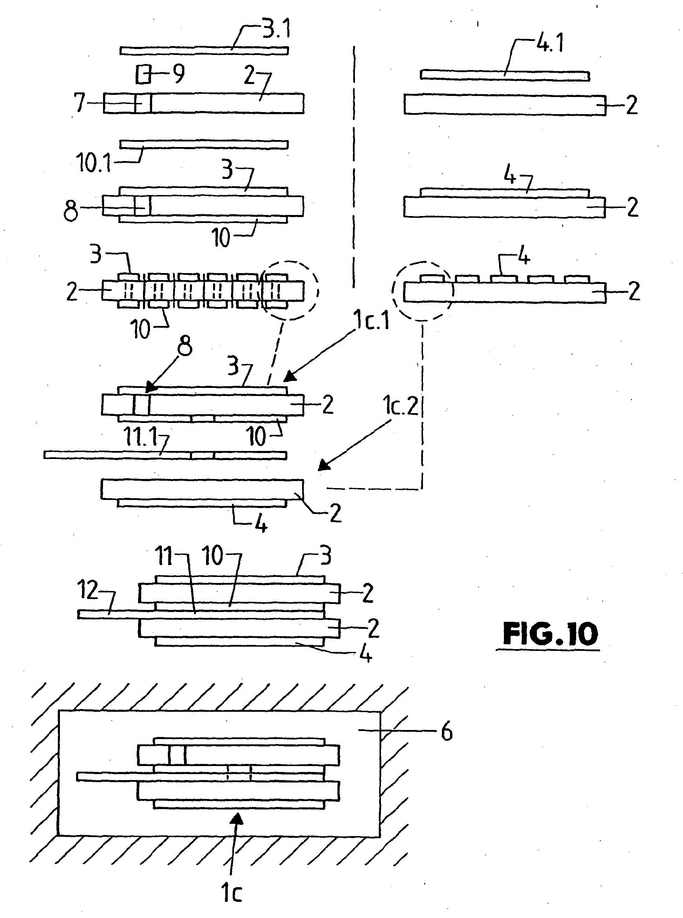

Die Herstellung des Substrates 1c erfolgt entsprechend der Figur 10 dadurch, dass zunächst zwei Einzelsubstrate 1c.1 und 1c.2 hergestellt werden, und zwar ein Einzelsubstrat 1c.1 bestehend aus einer Keramikschicht 2 und der oberen Metallschicht 3 sowie der Metallschicht 10 sowie ein weiteres Substrat 1c.2 bestehend aus der zweiten Keramikschicht 2 und der unteren Metallschicht 4. jedes Einzelsubstrat wird im Mehrfachnutzen gefertigt, d.h. jeweils zusammen mit einer Vielzahl gleichartiger Einzelsubstrate auf einer gemeinsamen Keramikplatte bzw. auf einem gemeinsamen Keramiksubstrat 2.

Als Ausgangsmaterial für die Fertigung der ersten Teilsubstrate wird ein Al₂O₃-Substrat mit den Abmessungen 130 x 180 mm und der Dicke von 0,63 mm verwendet, in die für durch die Durchkontaktierung 8 der Metall-Keramik-Substrate 1c Öffnungen 7 eingebracht sind. Für die Metallschichten 3 und 10 werden voroxidierte Zuschnitte 3.1 und 10.1 aus dem Kupferblech der Abmessungen 129 x 179 mm und einer Dicke von 0,3 mm verwendet. Nach dem Aufeinanderstapeln der Zuschnitte 3.1 und 10.1 sowie der Keramikschicht und Einbringen einer Ronde 9 in jede Öffnung 7 erfolgt durch Erhitzen die Prozess-Temperatur von ca. 1072° C und in einer Schutzgasatmoshphäre mit einem Sauerstoffgehalt < 20 ppm das Verbinden der Metallschichten 3 und 10 mit der Keramikschicht 2 sowie die Herstellung der Durchkontaktierungen 8 über die Ronden 9. Die jeweilige Öffnung 7 besitzt einen Durchmesser von etwa 0,9 mm und eine axiale Länge bzw. Höhe von 0,6 mm.

Nach dem Bonden erfolgt das Strukturieren der Metallschichten 3 und 10 beispielsweise durch Maskieren und Ätzen in die Metallisierungen der einzelnen Teilsubstrate 1c.1 und im Anschluss daran das Laser-Ritzen und das Zertrennen des Mehrfachsubstrates in diese einzelnen Teilsubstrate.

In ähnlicher Weise werden die aus der Keramikschicht 2 und der Metallschicht 4 bestehenden zweiten Teilsubstrate 1c.2 hergestellt, und zwar wiederum im Mehrfachnutzen unter Verwendung eines großformatigen Al₂O₃-Substrates mit den Abmessungen 130 x 180 mm und der Dicke von 0,63 mm und unter Verwendung eines die Metallschicht 4 bildenden Zuschnitts 4.1 aus der Kupferfolie mit den Abmessungen 129 x 179 mm und der Dicke von 0,63 mm.

Zum Verbinden der beiden Teilsubstrate 1c.1 und 1c.2 zu dem Metall-Keramik-Substrat 1c wird dann auf die freiliegende Oberflächenseite der Keramikschicht 2 des unteren Teilsubstrates 1c.2 ein die Metallschicht 11 bildendes flaches Stanzteil 11.1 aufgelegt und auf die Oberseite dieses Stanzteils dann das obere Teilsubstrat mit der freiliegenden Seite der Metallschicht 10 aufgesetzt. Das Stanzteil 11.1 ist wiederum aus einer Kupferfolie hergestellt und voroxidiert. In einem weiteren DCB-Prozess erfolgt dann bei der DCB-Temperatur von 1072° C und in einer Schutzgasatmosphäre mit einem Sauerstoffgehalt kleiner als 20 ppm das Verbinden der beiden Teilsubstrate 1c.1 und 1c.2 über das Stanzteil 11.1. Im Anschluss daran erfolgt die Nachbehandlung, und zwar bei einem Druck von 750 bar und einer Temperatur von 1030° C in einer Schutzgasatmosphäre mit einem Sauerstoffanteil von etwa 10 ppm.

Das Ergebnis ist das Metall-Keramik-Substrat 1c in Sandwichaufbau mit wenigstens einer Durchkontaktierung 8 zur Verbindung der Metallschicht 3 bzw. der von dieser Metallschicht gebildeten Leiterbahnen, Kontaktflächen usw. mit äußeren Anschlüssen 12. Die Anbindung der Metall- bzw. Kupferschichten in allen Ebenen ist größer als 95%. Eventuell vorhandene Fehlstellen besitzen einen Durchmesser wesentlich kleiner als 50 µm.

Die Erfindung wurde voranstehend an Ausführungsbeispielen beschrieben. Es versteht sich, dass zahlreiche Änderungen sowie Abwandlungen in Rahmen der durch die nachstehenden Ansprüche definierten Erfindung möglich sind.

### Bezugszeichenliste

- 1, 1a, 1c: Metall-Keramik-Substrat
- 1c.1, 1c.2: Teilsubstrat
- 2: Keramikschicht bzw. Keramiksubstrat
- 2.1: Schicht aus Al₂O₃
- 3, 4: Metallschicht
- 3.1,4.1: Zuschnitt
- 5: Fehlstelle
- 6: geschlossener Raum für die Nachbehandlung
- 7: Bohrung oder Loch für Durchkontaktierung
- 8: Durchkontaktierung
- 9: Teil- oder Kupferronde
- 10: Metallschicht
- 10.1: Zuschnitt
- 11: Metallschicht
- 11.1: Zuschnitt oder Stanzteil
- 12: Anschluss

## Patentansprüche

1. Verfahren zum Herstellen eines Metall-Keramik-Substrats, bei dem (Verfahren) auf mindestens einer Seite eines Keramiksubstrats oder einer Keramikschicht (2) eine Kupferschicht (3, 4, 10, 11) unter Verwendung des Direct-Copper-Bonding-Verfahrens aufgebracht wird, **dadurch gekennzeichnet,**
**dass** in einem nachfolgenden Verfahrensschritt das Metall-Keramik-Substrat oder - teilsubstrat bei einem Gasdruck (Nachbehandlungsdruck) im Bereich von 400 bis 2000 bar und bei einer Nachbehandlungstemperatur im Bereich zwischen 450 und 1060° C nachbehandelt wird.

2. Verfahren nach Anspruch 7, **dadurch gekennzeichnet, dass** das Aufbringen der Kupferschicht bei einer Fügetemperatur oder Prozess-Temperatur zwischen 1025°C und 1083°C erfolgt, und dass die Nachbehandlungstemperatur wenigstens 50% der Fügetemperatur und/oder maximal 95 bis 99% dieser Fügetemperatur oder Prozess-Temperatur des Direct-Copper-Bonding-Verfahrens beträgt.

3. Verfahren nach einem der vorhergehenden Ansprüche **dadurch gekennzeichnet, dass** die Gasatmosphäre der Nachbehandlung in Abhängigkeit von der Nachbehandlungstemperatur einen Sauerstoffanteil bzw. einen Sauerstoffpartialdruck aufweist, der größer ist als derjenige Partialdruck, bei dem eine Zersetzung der Bondgrenzfläche zwischen Kupfer und Keramik auftritt, der aber nach oben so begrenzt ist, dass keine nennenswerte Oxidations des Kupfers stattfindet.

4. Verfahren nach Anspruch 3, **dadurch gekennzeichnet, dass** der Sauerstoffpartialdruck bei einer Nachbehandlungstemperatur zwischen 900° C und 1060° C im Bereich zwischen 2 x 10⁻⁷ und 1 x 10⁻³ bar und bei einer Behandlungstemperatur zwischen 450° C und 900° C im Bereich zwischen 3 x 10⁻¹⁶ und 1 x 10⁻² bar liegt.

5. Verfahren nach einem der vorhergehenden Ansprüche, **gekennzeichnet durch** die Verwendung eines Inertgase als Druckgas bei der Nachbehandlung.

6. Verfahren nach Anspruch 5, **gekennzeichnet durch** die Verwendung von Argon oder Stickstoff als Druckgas bei der Nachbehandlung.

7. Verfahren nach einem der vorhergehenden Ansprüche, **dadurch gekennzeichnet, dass** die Dicke der wenigstens einen Keramikschicht in der Größenordnung von 0,2 bis 4 mm liegt,
und/oder
dass die Dicke der wenigstens einen Kupferschicht in der Größenordnung zwischen 0,07 und 1,0 mm liegt.

8. Verfahren nach einem der vorhergehenden Ansprüche, **dadurch gekennzeichnet, dass** zur Erzeugung wenigstens einer Durchkontaktierung (8) in wenigstens eine Keramikschicht (2) zumindest eine Öffnung (7) eingebracht ist, und dass auf den beiden Oberflächenseiten der Keramikschicht (2) im Bereich der Öffnung (7) vorgesehene Kupferschichten (3, 4) während der Nachbehandlung in die Öffnung hinein verformt und miteinander verbunden werden.

9. Verfahren nach einem der vorhergehenden Ansprüche, **dadurch gekennzeichnet, dass** für die Erzeugung wenigstens einer Durchkontaktierung in wenigstens einer Keramikschicht (2) wenigstens eine Öffnung (7) eingebracht ist, dass in diese Öffnung ein Körper (9) aus einem elektrisch teilenden Material eingesetzt wird, und dass während der Nachbehandlung die im Bereich der wenigstens einen Öffnung (7) an den beiden Oberflächenseiten der Keramikschicht (2) vorgesehenen Kupferschichten durch bleibende Verformung gegen den Metallkörper (9) angepresst und mit diesem verbunden werden.

10. Verfahren nach Anspruch 9, **dadurch gekennzeichnet, dass** der Durchmesser des Metallkörpers (7) gleich dem Durchmesser der Öffnung (7) ist,
und/oder
dass der metallkörper senkrecht zu den Oberflächenseiten der Keramikschicht (2) eine Länge aufweist, die gleich oder kleiner ist als die Dicke der Keramikschicht.

11. Verfahren nach einem der vorhergehenden Ansprüche, **dadurch gekennzeichnet, dass** zur Herstellung eines Metall-Keramik-Substrats in Sandwichaufbau wenigstens zwei Keramikschichten (2) über wenigstens eine zwischen diesen angeordnete Kupferschicht (10, 11) durch den DCB-Prozess miteinander verbunden werden, und/oder
dass zur Herstellung eines Metall-Keramik-Subslrats in Sandwichaufbau ein erstes Teilsubstrat (1c.1) mit wenigstens einer ersten Keramikschicht (2) und mit zwei Metallisierungen (3, 10) an den beiden Oberflächenseiten sowie ein zweites Teilsubstrat (1 c.2) mit wenigstens einer Keramikschicht (2) und zumindest einer Metallisierung (4) an einer Oberflächenseite der Keramikschicht unter Verwendung jeweils des DCB-Prozesses hergestellt werden und die beiden Teilsubstrate (1c.1, 1c.2) in einem weiteren DCB-Prozess über wenigstens eine Kupferschicht (10, 11) miteinander verbunden werden und dann in einem weiteren Verfahrensschritt die Nachbehandlung bei dem Nachbehandlungsdruck und der Nachbehandlungstemperatur erfolgt.

12. Verfahren nach einem der vorhergehenden Ansprüche, **dadurch gekennzeichnet,**
**dass** auf jede Keramikschicht (2) außenliegend wenigstens eine Kupferschicht (3, 4) mit dem DCB-Verfahren aufgebracht wird.

13. Verfahren nach einem der vorhergehenden Ansprüche, **dadurch gekennzeichnet,**
**dass** die wenigstens eine Metallisierung nach der Nachbehandlung strukturiert wird, und/oder
**dass** das Metall-Keramik-Substrat nach der Strukturierung der wenigstens einen Metallisierung in Einzelsubstrate zertrennt wird.

14. Verfahren nach einem der vorhergehenden Ansprüche, **dadurch gekennzeichnet,**
**dass** die Nachbehandlung bei einer Nachbehandlungstemperatur von 560°C und einen Nachbehandlungsdruck von 1900 bar erfolgt.

15. Verfahren nach einem der vorhergehenden Ansprüche 1 bis 13, **dadurch gekennzeichnet,**
**dass** die Nachbehandlung bei einer Nachbehandlungstemperatur von 950° C und bei einem Nachbehandlungsdruck von 900 bar erfolgt.

16. Verfahren nach einem der vorhergehenden Ansprüche 1 bis 13, **dadurch gekennzeichnet,**
**dass** die Nachbehandlung bei einer Nachbehandlungstemperatur von 1030° C und bei einem Nachbehandlungsdruck von 850 bar erfolgt.

17. Verfahren nach einem der vorhergehenden Ansprüche 1 bis 13 **dadurch gekennzeichnet,**
**dass** die Nachbehandlung bei einer Nachbehandlungstemperatur von 1030° C und einem Nachbehandlungsdruck von 750 bar erfolgt.

## Claims

1. Method for manufacturing a metal-ceramic substrate, in which a copper layer (3, 4, 10, 11) is applied to at least one side of a ceramic substrate or a ceramic layer (2) by using the direct copper bonding process, **characterised in that** in a subsequent method step the metal-ceramic substrate or part substrate is re-treated at a gas pressure (re-treating pressure) in the range from 400 to 2000 bar and at a re-treating temperature in the range between 450 and 1060°C.

2. Method according to claim 1 **characterised in that** applying the copper layer takes place at a joining temperature or process temperature between 1025°C and 1083°C, and that the re-treating temperature amounts to at least 50% of the joining temperature and/or a maximum 95 to 99% of this joining temperature or process temperature of the direct copper bonding process.

3. Method according to one of the preceding claims **characterised in that** the gas atmosphere of the re-treatment has in dependence on the re-treating temperature an oxygen content or an oxygen partial pressure which is greater than that partial pressure at which a decomposition of the bonding boundary surface between copper and ceramic takes place, but which is however restricted at the top so that no noticeable oxidation of the copper takes place.

4. Method according to claim 3 **characterised in that** the oxygen partial pressure with a re-treating temperature between 900°C and 1060°C lies in the region between 2 x 10⁻⁷ and 1 x 10⁻³ bar and with a treatment temperature between 450°C and 900°C lies in the region between 3 x 10^{-??} and 1 x 10⁻²⁻ bar.

5. Method according to one of the preceding claims **characterised by** the use of an inert gas as pressurised gas during the re-treatment.

6. Method according to claim 5 **characterised by** the use of argon or nitrogen as pressurised gas during the re-treatment.

7. Method according to one of the preceding claims **characterised in that** the thickness of the at least one ceramic layer lies in the order of 0.2 to 4 mm,
and/or
that the thickness of the at least one copper layer lies in the order of between 0.07 and 1.0 mm.

8. Method according to one of the preceding claims **characterised in that** in order to produce at least a through contact (8) at least one opening (7) is formed in at least one ceramic layer (2) and that copper layers (3, 4) provided on both surface sides of the ceramic layer (2) in the area of the opening (7) are deformed during the re-treatment into the opening and are connected to one another.

9. Method according to one of the preceding claims **characterised in that** for producing at least a through contact at least one opening (7) is formed in at least one ceramic layer (2), that a body (9) made of an electrically conductive material is inserted in this opening, and that during the re-treatment the copper layers provided in the area of the at least one opening (7) on both surface sides of the ceramic layer (2) are pressed by permanent deformation against the metal body (9) and connected to this.

10. Method according to claim 9 **characterised in that** the diameter of the metal body (7) is the same as the diameter of the opening (7),
and/or
that the metal body has perpendicular to the surface sides of the ceramic layer (2) a length which is equal to or less than the thickness of the ceramic layer.

11. Method according to one of the preceding claims **characterised in that** to manufacture a metal ceramic substrate at least two ceramic layers (2) are connected together by the direct copper bonding process in sandwich construction over at least one copper layer (10, 11) mounted between these ,
and/or
that to manufacture a metal-ceramic substrate in sandwich construction a first partial substrate (1c.1) with at least a first ceramic layer (2) and with two metal platings (3, 10) on the two surface sides as well as a second partial substrate (1c.2) with at least a ceramic layer (2) and at least one metal plating (4) on a surface side of the ceramic layer are each made by using the DCB process and the two partial substrates (1c.1, 1c.2) are connected to one another in a further DCB process over at least one copper layer (10, 11) and then in a further method step the re-treatment takes place at the re-treatment pressure and the re-treatment temperature.

12. Method according to one of the preceding claims **characterised in that** at least one copper layer (3, 4) is applied by the DCB process on the outside to each ceramic layer (2).

13. Method according to one of the preceding claims **characterised in that** the at least one metal plating is structured after the re-treatment
and/or
that the metal ceramic substrate is separated into individual substrates after the structuring of the at least one metal plating.

14. Method according to one of the preceding claims **characterised in that** the re-treatment takes place at a re-treatment temperature of 560°C and a re-treatment pressure of 1900 bar.

15. Method according to one of the preceding claims 1 to 13 **characterised in that** the re-treatment takes place at a re-treatment temperature of 950°C and at a re-treatment pressure of 900 bar.

16. Method according to one of the preceding claims 1 to 13 **characterised in that** the re-treatment takes place at a re-treatment temperature of 1030°C and at a re-treatment pressure of 850 bar.

17. Method according to one of the preceding claims 1 to 13 **characterised in that** the re-treatment takes place at a re-treatment temperature of 1030°C and a re-treatment pressure of 750 bar.

## Revendications

1. Procédé pour produire un substrat métal-céramique, dans lequel procédé une couche de cuivre (3, 4, 10, 11) est déposée sur au moins une face d'un substrat en céramique ou d'une couche de céramique (2) en utilisant le *procédé* DCB (Direct Copper Bonding), **caractérisé en ce que**, dans une étape de procédé ultérieure, le substrat ou la partie de substrat métal-céramique est retraité sous une pression de gaz (pression de retraitement) dans la plage de 400 à 2000 bars et à une température de retraitement dans la plage de 450 à 1060°C.

2. Procédé selon la revendication 1, **caractérisé en ce que** le dépôt de la couche de cuivre se fait à une température d'assemblage ou température de travail dans la plage de 1025°C à 1083°C et **en ce que** la température de retraitement est au minimum égale à 50% de la température d'assemblage et/ou au maximum égale à 95 à 99% de ladite température d'assemblage ou température de travail du procédé DCB.

3. Procédé selon l'une des revendications précédentes, **caractérisé en ce que** l'atmosphère gazeuse du retraitement présente en fonction de la température de retraitement une teneur en oxygène ou bien une pression partielle d'oxygène qui est plus élevée que la pression partielle à laquelle il se produit une décomposition de l'interface de liaison entre le cuivre et la céramique mais qui est limitée vers le haut de telle façon qu'il ne se produise aucune oxydation notable du cuivre.

4. Procédé selon la revendication 3, **caractérisé en ce que** la pression partielle d'oxygène se situe dans la plage de 2 x 10⁻⁷ à 1 x 10⁻³ bars à une température de retraitement comprise entre 900°C et 1060°C et dans la plage de 3 x 10⁻¹⁶ et 1 x 10⁻² bars à une température de traitement comprise entre 450°C et 900°C.

5. Procédé selon l'une des revendications précédentes, **caractérisé par** l'utilisation d'un gaz inerte comme gaz comprimé lors du retraitement.

6. Procédé selon la revendication 5, **caractérisé par** l'utilisation d'argon ou d'azote comme gaz comprimé lors du retraitement.

7. Procédé selon l'une des revendications précédentes, **caractérisé en ce que** l'épaisseur de ladite au moins une couche de céramique est de l'ordre de 0,2 à 4 mm et/ou **en ce que** l'épaisseur de ladite au moins une couche de cuivre est de l'ordre de 0,07 à 1,0 mm.

8. Procédé selon l'une des revendications précédentes, **caractérisé en ce que**, pour créer au moins un trou métallisé (8) dans au moins une couche de céramique (2), on réalise un orifice (7) et **en ce que**, lors du retraitement, les couches de cuivre (3, 4) prévues sur les deux faces de la couche de céramique (2) dans la zone de l'orifice (7) sont déformées de façon à pénétrer dans l'orifice et reliées entre elles.

9. Procédé selon l'une des revendications précédentes, **caractérisé en ce que**, pour créer au moins un trou métallisé dans au moins une couche de céramique (2), on réalise au moins un orifice (7) et on introduit dans cet orifice un corps (9) en matériau électriquement conducteur et **en ce que**, lors du retraitement, les couches de cuivre prévues dans la zone dudit au moins un orifice (7) sur les deux faces de la couche de céramique (2) sont pressées par déformation permanente contre le corps métallique (9) et reliées à ce dernier.

10. Procédé selon la revendication 9, **caractérisé en ce que** le diamètre du corps métallique (7) est égal au diamètre de l'orifice (7) et/ou **en ce que** le corps métallique présente perpendiculairement aux faces de la couche de céramique (2) une longueur égale ou inférieure à l'épaisseur de la couche de céramique.

11. Procédé selon l'une des revendications précédentes, **caractérisé en ce que**, pour produire un substrat métal-céramique à structure sandwich, on relie entre elles au moins deux couches de céramique (2) par l'intermédiaire d'au moins une couche de cuivre (10, 11) disposées entre elles par le procédé DCB et/ou **en ce que**, pour produire un substrat métal-céramique à structure sandwich, on réalise une première partie de substrat (1c.1) qui comprend au moins une première couche de céramique (2) et deux métallisations (3, 10) sur les deux faces ainsi qu'une deuxième partie de substrat (1c.2) qui comprend au moins une couche de céramique (2) et au moins une métallisation (4) sur une face de la couche de céramique, à chaque fois en utilisant le procédé DCB, et, dans un autre procédé DCB, on relie entre elles les deux parties de substrat (1c.1, 1c.2) par l'intermédiaire d'au moins une couche de cuivre (10, 11) puis, dans une autre étape de procédé, on soumet l'ensemble au retraitement sous la pression de retraitement et à la température de retraitement.

12. Procédé selon l'une des revendications précédentes, **caractérisé en ce qu'**au moins une couche de cuivre (3, 4) est déposée par le procédé DCB sur la face extérieure de chaque couche de céramique (2).

13. Procédé selon l'une des revendications précédentes, **caractérisé en ce que** ladite au moins une métallisation est structurée après le retraitement et/ou
**en ce que** le substrat métal-céramique est découpé en substrats individuels après la structuration de ladite au moins une métallisation.

14. Procédé selon l'une des revendications précédentes, **caractérisé en ce que** le retraitement se fait à une température de retraitement de 560°C et sous une pression de retraitement de 1900 bars.

15. Procédé selon l'une des revendications précédentes 1 à 13, **caractérisé en ce que** le retraitement se fait à une température de retraitement de 950°C et sous une pression de retraitement de 900 bars.

16. Procédé selon l'une des revendications précédentes 1 à 13, **caractérisé en ce que** le retraitement se fait à une température de retraitement de 1030°C et sous une pression de retraitement de 850 bars.

17. Procédé selon l'une des revendications précédentes 1 à 13, **caractérisé en ce que** le retraitement se fait à une température de retraitement de 1030°C et sous une pression de retraitement de 750 bars.
